# EUROPEAN PATENT SPECIFICATION

(11) **EP 2 482 454 B1**
(45) Date of publication and mention of the grant of the patent: **27.11.2013**
(21) Application number: 12152103.3
(22) Date of filing: 23.01.2012
(51) Int. Cl.: H03K 5/1534, G01R 19/14

(54) **Device detecting of a signal flank on a bus with unknown polarity**
Gerät zur Erfassung einer Signalflanke eines Buses mit unbekannter Polarität
Appareil de detection d'un front de signal d'un bus à polarité indefinie

(30) Priority: 28.01.2011 BE 201100054
(43) Date of publication of application: 01.08.2012
(73) Proprietor: Niko NV, 9100 Sint-Niklaas (BE)
(72) Inventor: Veldeman, Pol, 9140 Temse (BE)
(74) Representative: D'Halleweyn, Nele Veerle Trees Gertrudis

(56) References cited:
- WO-A1-2009/053384
- WO-A1-2010/150183
- BE-A1- 898 044
- DE-A1- 2 060 884
- JP-A- 52 122 453
- US-A- 4 450 384
- US-A1- 2007 182 338

## Description

The present invention relates to a bus device of the preamble of claim 1.

JP 52122453 relates to a circuit for detecting a rising and a falling edge, said circuit comprising an amplifier.

US2007/0182338 discloses a current regulator for controlling various brightness levels.

In the bus devices of the prior art which are intended to be connected to a non-polarized bus, the modulation pulse is typically measured after the rectifier circuit. In this case, a measurement circuit with a relatively low input impedance should be used to accurately measure the modulation signal. This will cause the power required for the measurement to be relatively high and the number of devices which can be coupled to the bus will be limited.

The term "bus device" comprises any device or appliance, such as a light switch, an outlet, din rail module etc., which is connectable to a non-polarized bus. More in particular, it relates to a bus device which is connectable to the bus of an automation or home automation system in a building such as a house or an industrial building.

The present invention aims at providing a bus device of the preamble of claim 1 that has a low consumption, is compact, and in particular allows a large number of bus devices to be connected to a single non-polarized bus without having to give in on modulation signal integrity.

To this end, the bus device according to the invention is distinguished by the features of the characterizing portion of claim 1. The bus device comprises a rectifier circuit having a first and a second input which are connected with a first and a second wire of the non-polarized bus respectively. The device comprises a differentiator, a bias voltage circuit and a comparator. The differentiator is arranged to differentiate the power signal modulated with the modulation signal to detect a flank of the modulation signal. Hence, the differentiator is designed to be directly connected to the bus in front of the rectifier circuit of the bus device. The bias voltage circuit is designed to provide a bias voltage. The comparator is coupled to the differentiator and the bias voltage circuit in such a way that an output signal is obtained which is representative for the modulation signal and suitable for further processing by, for example, a microcontroller. Preferably, the differentiator and the bias voltage circuit are connected to the comparator such that the voltage at the input of the comparator:
- in the event no modulation signal is modulated on the power signal, is a voltage determined by the bias voltage, and
- in the event a modulation signal is modulated on the power signal, exhibits a voltage gradient determined by the differentiator.

The use of a measuring device with a differentiator designed to differentiate the power signal on the non-polarized bus modulated with the modulation signal, and hence, intended to be directly connected to the bus, in front of the rectifier circuit, has the advantage that the measuring device may be designed as a low-power circuit. By using on the one hand a bias circuit, and on the other hand a differentiator, the sensitivity of the measurement may simply be set by selecting an appropriate value for the bias voltage.

According to a preferred embodiment, the differentiator has a high impedance, preferably more than 10 kΩ, and even more preferably more than 100 kΩ. Preferably, the differentiator is a high-pass filter. Even more preferably, the differentiator is a circuit which is symmetrical with respect to the wires of the bus. Because of this symmetry, and by providing a bias voltage circuit, a high CMR (Common Mode Rejection) can be obtained for interferences between the primary and secondary, i.e. between the input of the rectifier circuit and the output of the rectifier circuit.

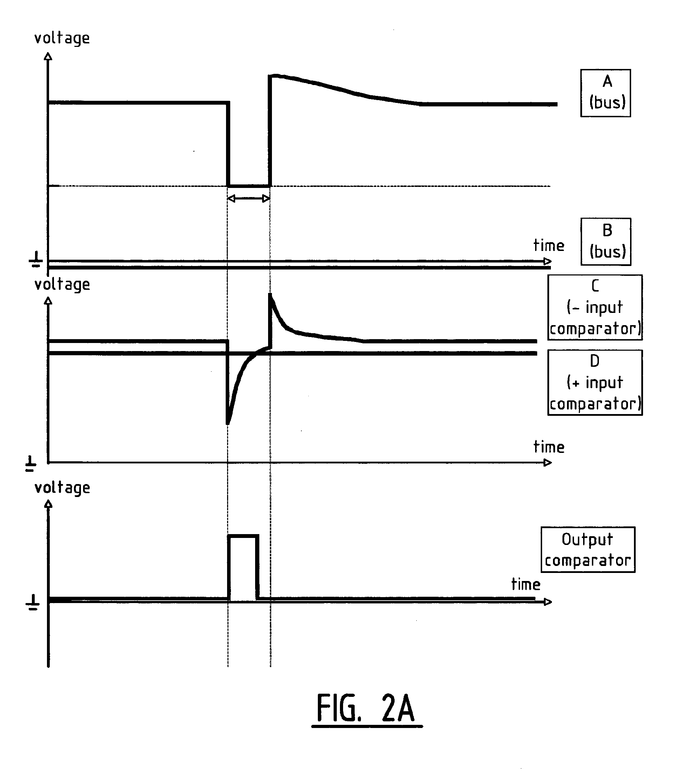

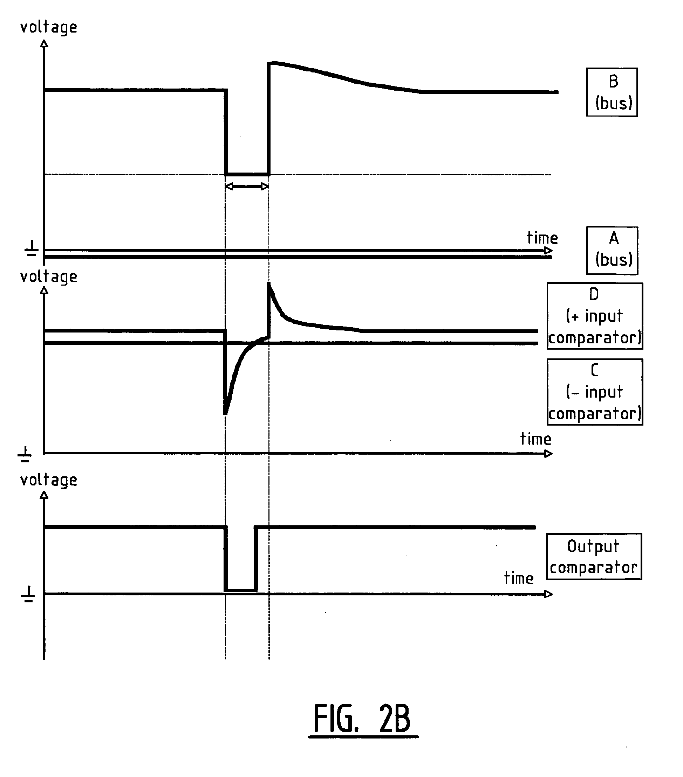

According to a preferred embodiment, the device further comprises a polarity detection circuit arranged to detect the polarity of the power signal on the non-polarized bus and to provide a detection signal. The bias voltage circuit is preferably arranged to set the polarity of the bias voltage as a function of the detection signal. The polarity detection circuit can be directly coupled to the voltage bias circuit or can be connected to the bias voltage circuit using a microcontroller. In this way, independently of the polarity of the power signal on the bus, the same flank can be detected with the comparator. This is schematically illustrated in Figures 2A and 2B, see below.

According to a particularly preferred embodiment, the differentiator is a high-pass filter comprising an RC circuit with:
- a first series circuit of a capacitor and at least one resistor, which first series circuit is at one end connected with a first wire of the bus and at another end with a first input of the comparator, and
- a second series circuit of a capacitor and at least one resistor, which second series circuit is at one end connected with the second wire of the bus and at another end with a second input of the comparator.

In this way, a simple, inexpensive circuit is obtained which can be carried out symmetrically. It is noted that the differentiator does not necessarily need to be symmetrical and that not-symmetrical circuits are also comprised within the scope of the invention.

According to a further developed embodiment, the bias voltage circuit has a first output and a second output between which the bias voltage is set and is the first output connected by a first resistor to the first input of the comparator and by a second resistance to a second input of the comparator. In this way, a voltage divider can be obtained which will ensure that the amplitude of a pulse on the bus is converted into a pulse with a smaller amplitude between the first and second input of the comparator.

According to an advantageous embodiment, the bus device further comprises a microcontroller for processing the output signal.

According to a further developed embodiment, the bus device further comprises a modulation circuit, arranged to superimpose on the bus a modulation signal to be send. Also, the microcontroller can be arranged for controlling the modulation circuit.

Furthermore, the bus device typically comprises a power supply decoupler, arranged for providing a decoupled power signal for powering various components of the bus device.

The present invention will be elucidated using a number of non-limiting embodiments of a device and a bus device of the invention with reference to the drawings attached. The drawing shows in:
Figure 1 a block diagram of a first embodiment of a bus device of the invention;
Figure 2A schematically the voltage gradient at the inputs A, B of the bus device, at the inputs C, D of the comparator, and at the output of the comparator, for the bus device of Figure 1, in case the voltage A exceeds voltage B (polarity 1);
Figure 2B schematically the voltage gradient at the inputs A, B of the bus device, at the inputs C, D of the comparator, and at the output of the comparator, for the bus device of Figure 1, in case the voltage B exceeds voltage A (polarity (2);
Figure 2C schematically the voltage gradient at the inputs A, B of the bus device, at the inputs C, D of the comparator and at the output of the comparator, for the bus device of Figure 1, in case the voltage B exceeds voltage A (polarity 2) and no polarity detection is performed;

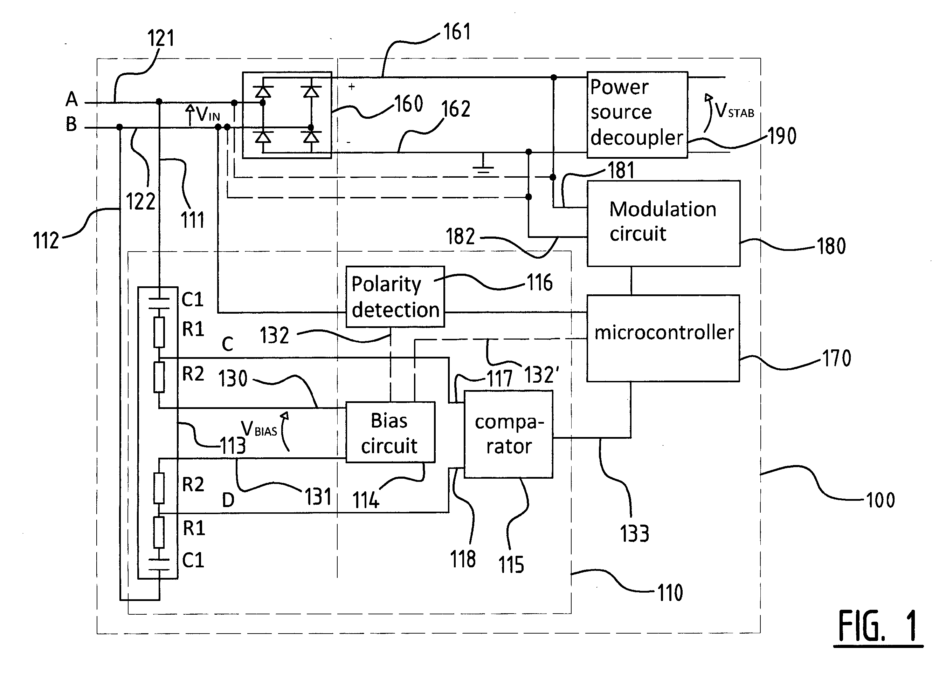

Figure 1 schematically illustrates an embodiment of a bus device 100 according to the invention. The bus device 100 includes a receiver circuit 110. This receiver circuit 110 is designed to measure a modulation signal modulated on a power signal on a non-polarized bus 121, 122. The non-polarized bus is a 2-wire bus with a first electrical wire 121 and a second electrical wire 122. A first input 111 of the receiving circuit 110 is connected to a first wire 121 and a second input 112 is connected to the second wire 122 of the bus. An input signal Vᵢₙ (A-B) is formed by a power signal on which a modulation signal is superimposed.

As an example, a power signal and pulse modulation technique will now be described to illustrate the invention. However, the skilled person will understand that the magnitude of the voltage supply signal may differ and that different bus modulation techniques exist to which the invention is equally applicable. The 2-wire bus is powered by a DC power supply in series with a coil, for example a DC voltage between 15 V and 50 V. To modulate the bus voltage, the bus voltage is reduced for a short time. The data to be modulated is encoded as a sequence of pulses. The time between successive pulses contains the actual information.

Figure 2A schematically illustrates a bus signal comprising a power signal of 26 V on which a pulse is superimposed, for a first polarity, see the signals A and B. Figure 2B illustrates a similar bus signal for a second polarity, i.e. instead of the voltage signal A, the voltage signal B consists of a power signal on which the pulse is modulated.

The input signal Vᵢₙ is differentiated by using a differentiator 113 adapted for detecting a flank of the modulation signal. As will be exemplified hereafter, within the scope of the invention can be opted to only detect a falling flank, to only detect a rising flank, or to detect both a falling and a rising flank. This choice will typically depend on the accuracy or precision defining a falling or rising flank and/or the modulation technique used.

A bias voltage circuit 114 provides a bias voltage V_{bias}. The bias voltage circuit is connected to the comparator 115 such that the bias voltage V_{bias} determines the voltage between input terminals 117 and 118 of the comparator when no flank is detected by the differentiator.

In the illustrated embodiment, the differentiator 113 is a passive high-pass filter with two RC circuits. A first RC circuit comprises a capacitor C1 in series with a resistor R1 and a resistor R2. This first series circuit is connected between a first input terminal 111 of the receiving circuit and an output 130 of the bias voltage circuit 114. In an analogous manner, the second input 112 of the receiver circuit is connected via a series connection of a capacitor C1 and two resistors R1, R2 to the second output of the bias voltage circuit 131. As long as the input signal Vᵢₙ shows no flanks, no current will flow over the resistors R1 and R2 and consequently, the bias voltage V_{bias} is applied across the input terminals 117, 118 of comparator 115. Upon detecting a falling or rising flank, current will flow over the resistors R1 and R2 and the voltage between the input terminals 117, 118 will change.

The voltage profile on the inputs C and D of the comparator and on the output of the comparator is shown in Figure 2A. As a result of the differentiator, the voltage at the input C of the comparator will be equal to the voltage at the output 130 of the bias voltage circuit as long as the voltage signal A is constant. When a falling flank appears, the voltage C also decreases due to the presence of the capacitor C1, wherein the ratio between the voltage dip on the bus (V_{dipbus}) and the voltage dip at the input of the comparator is approximately determined by the voltage divider R1, R2: V_{CD} = U_{dipbus} * R2/R1 (R1 + R2) . In an analogous manner, the voltage C will show a rising flank the moment the bus signal A shows a rising flank.

Depending on the modulation techniques used, it will typically be preferred to detect one particular flank, mostly the falling flank because it is often the "cleanest" flank. To this end, a polarity detection circuit 116 is provided which is arranged to detect which wire 121, 122 is the most positive. The polarity detection circuit 116 is connected via a connection 132 to the bias voltage circuit for providing a detection signal. The bias voltage circuit may provide a bias voltage V_{bias} as a function of the detection signal. More in particular, the polarity of the bias voltage V_{bias} will be changed when the polarity detected by the polarity detection circuit 116 is changed. Furthermore, the bias voltage circuit allows to set the sensitivity of the receiving circuit by changing the size of the bias voltage V_{bias}. Note that the link between the polarity detection circuit 116 and the bias voltage circuit 114 may also be established indirectly using a microcontroller 170, see link 132'.

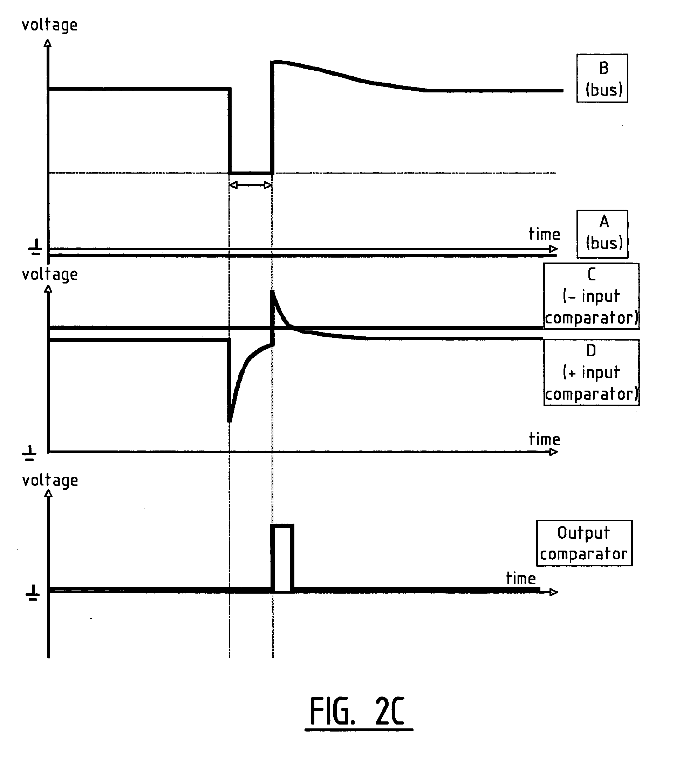

The comparator 115 converts the typically small voltage between the input terminals 117, 118 into an output signal at output 133 which is compatible with a microcontroller 170 of the bus device. As illustrated in the example of Figure 2A, the comparator may be arranged to only detect the falling flank. Figure 2B illustrates the voltage gradient for a second polarity on the bus wherein the voltage B exceeds the voltage A. In this case, the polarity detection circuit will detect the changed polarity and ensure that the polarity of the bias voltage circuit changes. As a result of this change, the voltage D now exceeds voltage C when no modulating signal is present. In this way, it is ensured that the comparator also detects the falling flank at a changed polarity on the bus. In this way, it is possible, independently of the polarity, to detect the falling flank, which is particularly advantageous when only the falling flank is a "clean" flank, see also the previous section. Figure 2C illustrates another possible embodiment wherein the polarity detection circuit of Figure 1 is omitted. In the case of the changed polarity of the bus, in this case, the comparator will not detect the falling flank but the rising flank. Hence, in an embodiment wherein both the rising flank and the falling flank are sufficiently sharply defined, the system of the invention may also function without polarity detection circuit.

The microcontroller 170 processes the output signal and may control, as a function of the processed output signal, the necessary components of the bus device. In addition, the microcontroller 170 will typically be responsible for composing the modulation signals to be send and for controlling a number of non-bus related functions such as a user interface or a function for measuring the temperature.

Furthermore, the bus device 100 will typically comprise a modulation circuit 180. The modulation circuit is arranged to superimpose onto the power signal on the bus a modulation signal to be send. This modulation signal is composed by the microcontroller 170. Note that the outputs 181, 182 of the modulation circuit 180 may be connected to the bus both in front of and after the rectifier circuit. According to one possible embodiment, the modulation circuit 180 comprises a current-limited voltage source.

The rectifier circuit 160 is arranged to rectify the input signal Vᵢₙ for providing a rectified signal V_{rec}. This rectified signal V_{rec} is presented to a source decoupler arranged to extract power from the 2-wire bus 121, 122 without disturbing the data signal superimposed thereon. In this way, in the bus device 100 a stable constant voltage is provided that can be used to power various components of the bus device such as the microcontroller 170. Furthermore, the power decoupler 190 is intended to maintain the current extracted by the bus device 100 from the 2-wire bus 121, 122 substantially constant when the bus is modulated. This is particularly important when a large number of devices are connected to the bus and when the modulation current is less than the total power used by the bus devices. The power decoupler may for example be arranged as a linear controller with low capacitance input circuit. The advantage is that such a decoupler can be built from discrete components, simple and cheap is. Such a solution can be used, for example, for power bus devices, such as wall switches. According to another possibility, a parallel controller can be used suitable for high power applications.

Now, the dimensioning of the components of the differentiator 113 and of the bias voltage circuit 114 will be explained. In a DC-situation, the voltage difference V_{CD} is equal to V_{bias}. In an AC-situation in which a voltage dip V_{dip}-bus occurs on the bus, the voltage V_{CD} is equal to V_{dipbus} * R2/(R1 + R2). To keep the load on the bus as low as possible, both in terms of DC current and capacitive load, it is preferable to keep C1 relatively low and to keep R1 relatively large, for example between 10 pF and 200 pF C1 and R1 between 100 K and 1 M.

Furthermore, the time constant of the differentiator, which is approximately equal to R1 * C1 in case R2 is considerably smaller than R1, is preferably adapted to the bus communication speed and maximum length of bus cabling. For the above-illustrated modulation technique, the time constant my range between 5 µsec and 30 µsec. Based on the value chosen for C1, a suitable value for R1 may be chosen. Furthermore, the specification of the comparator will typically determine the maximum input voltage at the terminals of the comparator. Depending on the specifications of the comparator and the largest modulation depth, an appropriate value for the resistor R2 can be calculated. Hence, the DC voltage difference V_{bias} is selected such that the desired sensitivity of the receiving circuit is achieved.

The comparator circuit 115 is for example a classic comparator circuit and will therefore not further be elucidated.

The skilled person will appreciate that many modifications and additions are conceivable within the scope of the present invention which is by no means limited by the above embodiments. The scope is determined solely by the appended claims.

## Claims

1. Bus device comprising a device for detecting a flank of a modulation signal modulated on a power signal on a non-polarized bus (121, 122), and a rectifier circuit (160) having a first and second input which are respectively connected with a first and second wire of the non-polarized bus, **characterized in that** said device comprises:
- a differentiator (113) for differentiating the power signal modulated with the modulation signal, which differentiator is arranged to detect a flank of the modulation signal;
- a bias voltage circuit (114) for providing a bias voltage;
- a comparator (115) coupled to the differentiator and the bias voltage circuit in such a way that an output signal is obtained indicating a flank of the modulation signal;
wherein the differentiator is further connected with the first and the second wire;
wherein the modulation signal is a pulse signal.

2. Bus device according to claim 1, **characterized in that** the differentiator (113) and the bias voltage circuit (114) are connected to the comparator (115) such that the voltage at the input of the comparator:
- in the event no modulation signal is modulated on the power signal, is a voltage determined by the bias voltage, and
- in the event a modulation signal is modulated on the power signal, exhibits a voltage gradient determined by the differentiator.

3. Bus device according to claim 1 or 2, **characterized in that** the differentiator has a high impedance, and is in particular a high-pass filter.

4. Bus device according to any one of the preceding claims, **characterized in that** the differentiator is a circuit which is symmetrical with respect to the wires of the bus.

5. Bus device according to claim 1 to 3, **characterized in that** the device further comprises a polarity detection circuit (116), arranged to detect the polarity of the power signal on the non-polarized bus and to provide a detection signal to the bias voltage circuit.

6. Bus device according to claim 5, **characterized in that** the bias voltage circuit (114) is arranged to set the polarity of the bias voltage as a function of the detection signal.

7. Bus device according to any one of the preceding claims, wherein the bus is a 2-wire bus with a first and a second wire, and the comparator has a first and a second input, **characterized in that** the differentiator (111) comprises an RC-circuit with:
- a first series circuit of a capacitor (C1) and at least one resistor (R1), which first series circuit is at one end connected with the first wire and at another end with the first input of the comparator; and
- a second series circuit of a capacitor (C1) and at least one resistor (R1), which second series circuit is at one end connected with the second wire and at another end with the second input of the comparator.

8. Bus device according to any one of the preceding claims, **characterized in that** the comparator (115) has a first and a second input, in between which a series circuit of the bias voltage circuit (114) and at least one resistor (R2) is provided.

9. Bus device according to any one of the preceding claims, **characterized in that** the bias voltage circuit (114) has a first output and a second output in between which the bias voltage is supplied, and **in that** the first output is connected by means of a first resistor (R2) to the first input of the comparator and by a second resistor (R2) to a second input of the comparator.

10. Bus device according to claim 1, further comprising a microcontroller (170) for processing the output signal.

11. Bus device according to any of the previous claims, further comprising a modulation circuit (180) arranged to superimpose on the bus a modulation signal to be send.

12. Bus device according to any of the previous claims, further comprising a power decoupler (190) arranged to provide a decoupled power signal for powering various components of the bus device.

## Patentansprüche

1. Busgerät, umfassend eine Vorrichtung zum Erkennen einer Flanke eines Modulationssignals, das an einem Stromsignal an einem nichtpolarisierten Bus (121, 122) moduliert wird, und eine Gleichrichterschaltung (160) mit einem ersten und einem zweiten Eingang, die mit einem ersten bzw. einem zweiten Draht des nichtpolarisierten Busses verbunden sind, **dadurch gekennzeichnet, dass** die Vorrichtung Folgendes umfasst:
- einen Differenzierer (113) zum Differenzieren des mit dem Modulationssignal modulierten Stromsignals, wobei der Differenzierer angeordnet ist, um eine Flanke des Modulationssignals zu erkennen;
- eine Vorspannungsschaltung (114) zum Bereitstellen einer Vorspannung;
- einen Komparator (115), der so mit dem Differenzierer und der Vorspannungsschaltung verbunden ist, dass ein Ausgabesignal erhalten wird, das eine Flanke des Modulationssignals anzeigt;
wobei der Differenzierer ferner mit dem ersten und dem zweiten Draht verbunden ist;
wobei das Modulationssignal ein Impulssignal ist.

2. Busgerät nach Anspruch 1, **dadurch gekennzeichnet, dass** der Differenzierer (113) und die Vorspannungsschaltung (114) so mit dem Komparator (115) verbunden sind, dass die Spannung am Eingang des Komparators:
- wenn kein Modulationssignal am Stromsignal moduliert wird, eine Spannung ist, die von der Vorspannung bestimmt wird, und
- wenn ein Modulationssignal am Stromsignal moduliert wird, einen Spannungsgradienten aufweist, der vom Differenzierer bestimmt wird.

3. Busgerät nach Anspruch 1 oder 2, **dadurch gekennzeichnet, dass** der Differenzierer eine hohe Impedanz aufweist und insbesondere ein Hochpassfilter ist.

4. Busgerät nach einem der vorstehenden Ansprüche, **dadurch gekennzeichnet, dass** der Differenzierer eine Schaltung ist, die in Bezug auf die Drähte des Busses symmetrisch ist.

5. Busgerät nach Anspruch 1 bis 3, **dadurch gekennzeichnet, dass** die Vorrichtung ferner eine Polaritätserkennungsschaltung (116) umfasst, die angeordnet ist, um die Polarität des Stromsignals am nichtpolarisierten Bus zu erkennen und um ein Erkennungssignal an die Vorspannungsschaltung zu bereitzustellen.

6. Busgerät nach Anspruch 5, **dadurch gekennzeichnet, dass** die Vorspannungsschaltung (114) angeordnet ist, um die Polarität der Vorspannung als eine Funktion des Erkennungssignals einzustellen.

7. Busgerät nach einem der vorstehenden Ansprüche, wobei der Bus ein 2-Draht-Bus mit einem ersten und einem zweiten Draht ist und der Komparator einen ersten und einen zweiten Eingang aufweist, **dadurch gekennzeichnet, dass** der Differenzierer (111) eine RC-Schaltung umfasst, die Folgendes aufweist:
- eine erste Reihenschaltung eines Kondensators (Cl) und mindestens eines Widerstands (Rl), wobei die erste Reihenschaltung an einem Ende mit dem ersten Draht und an einem anderen Ende mit dem ersten Eingang des Komparators verbunden ist; und
- eine zweite Reihenschaltung eines Kondensators (Cl) und mindestens eines Widerstands (Rl), wobei die zweite Reihenschaltung
an einem Ende mit dem zweiten Draht und an einem anderen Ende mit dem zweiten Eingang des Komparators verbunden ist.

8. Busgerät nach einem der vorstehenden Ansprüche, **dadurch gekennzeichnet, dass** der Komparator (115) einen ersten und einen zweiten Eingang aufweist, zwischen denen eine Reihenschaltung der Vorspannungsschaltung (114) und mindestens eines Widerstands (R2) bereitgestellt ist.

9. Busgerät nach einem der vorstehenden Ansprüche, **dadurch gekennzeichnet, dass** die Vorspannungsschaltung (114) einen ersten Ausgang und einen zweiten Ausgang aufweist, zwischen denen die Vorspannung bereitgestellt ist, und dadurch, dass der erste Ausgang über einen ersten Widerstand (R2) mit dem ersten Eingang des Komparators und über einen zweiten Widerstand (R2) mit einem zweiten Eingang des Komparators verbunden ist.

10. Busgerät nach Anspruch 1, das ferner einen Microcontroller (170) zum Verarbeiten des Ausgabesignals umfasst.

11. Busgerät nach einem der vorstehenden Ansprüche, das ferner eine Modulationsschaltung (180) umfasst, die angeordnet ist, um an dem Bus ein zu sendendes Modulationssignal zu überlagern.

12. Busgerät nach einem der vorstehenden Ansprüche, das ferner einen Stromentkoppler (190) umfasst, der angeordnet ist, um ein entkoppeltes Stromsignal zum Betreiben verschiedener Komponenten des Busgeräts bereitzustellen.

## Revendications

1. Dispositif de bus comprenant un dispositif de détection d'un flanc de signal de modulation modulé sur un signal de puissance sur un bus non polarisé (121, 122), et un circuit redresseur (160) ayant une première et une seconde entrée, respectivement connectées à un premier et un second fil du bus non polarisé, **caractérisé en ce que** ledit dispositif comprend :
- un différentiateur (113) pour différentier le signal de puissance modulé avec le signal de modulation, lequel différentiateur est agencé pour détecter un flanc du signal de modulation ;
- un circuit de tension de polarisation (114) pour produire une tension de polarisation ;
- un comparateur (115) couplé au différentiateur et au circuit de tension de polarisation, de sorte qu'un signal de sortie est obtenu, indiquant un flanc du signal de modulation ;
dans lequel le différentiateur est en outre connecté au premier et au seconde fil; dans lequel le signal de modulation est un signal d'impulsions.

2. Dispositif de bus selon la revendication 1, **caractérisé en ce que** le différentiateur (113) et le circuit de tension de polarisation (114) sont connectés au comparateur (115) de sorte que la tension à l'entrée du comparateur :
- dans le cas où aucun signal de modulation n'est modulé sur le signal de puissance, est une tension déterminée par la tension de polarisation et
- dans le cas où un signal de modulation est modulé sur le signal de puissance, présente un gradient de tension déterminé par le différentiateur.

3. Dispositif de bus selon la revendication 1 ou 2, **caractérisé en ce que** le différentiateur a une impédance élevée et est en particulier un filtre passe-haut.

4. Dispositif de bus selon l'une quelconque des revendications précédentes, **caractérisé en ce que** le différentiateur est un circuit qui est symétrique par rapport aux fils du bus.

5. Dispositif de bus selon la revendication 1 à 3, **caractérisé en ce que** le dispositif comprend en outre un circuit de détection de polarité (116), conçu pour détecter la polarité du signal de puissance sur le bus non polarisé et pour produire un signal de détection au circuit de tension de polarisation.

6. Dispositif de bus selon la revendication 5, **caractérisé en ce que** le circuit de tension de polarisation (114) est conçu pour régler la polarité de la tension de polarisation en fonction du signal de détection.

7. Dispositif de bus selon l'une quelconque des revendications précédentes, dans lequel le bus est un bus à 2 fils avec un premier et un second fil et le comparateur a une première et une seconde entrée, **caractérisé en ce que** le différentiateur (111) comprend un circuit RC avec :
- un premier circuit en série d'un condensateur (Cl) et au moins une résistance (R1), ledit premier circuit en série étant connecté à une extrémité au premier fil et à une autre extrémité à la première entrée du comparateur ; et
- un second circuit en série d'un condensateur (Cl) et au moins une résistance (R1), ledit second circuit en série est connecté à une extrémité au second fil et à l'autre extrémité à la seconde entrée du comparateur.

8. Dispositif de bus selon l'une quelconque des revendications précédentes, **caractérisé en ce que** le comparateur (115) présente une première et une seconde entrée, entre lesquelles un circuit en série du circuit de tension de polarisation (114) et au moins une résistance (R2) sont prévus.

9. Dispositif de bus selon l'une quelconque des revendications précédentes, **caractérisé en ce que** le circuit de tension de polarisation (114) présente une première sortie et une seconde sortie entre lesquelles la tension de polarisation est fournie et **en ce que** la première sortie est connectée au moyen d'une première résistance (R2) à la première entrée du comparateur et par une seconde résistance (R2) à une seconde entrée du comparateur.

10. Dispositif de bus selon la revendication 1, comprenant en outre un microcontrôleur (170) pour le traitement du signal de sortie.

11. Dispositif de bus selon l'une quelconque des revendications précédentes, comprenant en outre un circuit de modulation (180) conçu pour superposer sur le bus un signal de modulation à envoyer.

12. Dispositif de bus selon l'une quelconque des revendications précédentes, comprenant en outre un élément de découplage de puissance (190) conçu pour fournir un signal de puissance découplé pour alimenter différents composants du dispositif de bus.
